Europäisches Patentamt

European Patent Office

Office européen des brevets

(11) Numéro de publication: **0 200 592**

**A1**

# (12) DEMANDE DE BREVET EUROPEEN

(21) Numéro de dépôt: **86400631.7**

(22) Date de dépôt: **25.03.86**

(51) Int. Cl.4: **H03K 17/94** , H03K 17/18

(30) Priorité: **01.04.85 FR 8505489**

(43) Date de publication de la demande:
**10.12.86 Bulletin 86/45**

(84) Etats contractants désignés:
**AT BE CH DE GB IT LI LU NL SE**

(71) Demandeur: **Vissiere, Daniel**
**En Pinaud Montgaillard**
**F-31290 Villefranche-de-Lauragais(FR)**

(72) Inventeur: **Vissiere, Daniel**
**En Pinaud Montgaillard**
**F-31290 Villefranche-de-Lauragais(FR)**

(74) Mandataire: **Mongrédien, André et al**
**c/o SOCIETE DE PROTECTION DES**
**INVENTIONS 25, rue de Ponthieu**
**F-75008 Paris(FR)**

(54) **Commutateur statique à commande manuelle.**

(57) L'invention concerne un commutateur statique a commande manuelle.

Ce commutateur comprend un corps (1,51) comportant une gorge (2,56) avec une paroi de fond (5), bordée de chaque côté par une première (6) et une seconde (7) rainures, de façon que la gorge (2) ait au moins deux parois (3,4) transparentes à un rayonnement électromagnétique, situées latéralement à la paroi de fond, sensiblement parallèles entre elles, un émetteur (13,52) de faisceaux de rayonnement électromagnétique disposé dans la première rainure (6) de façon à envoyer les faisceaux vers ladite seconde rainure (7), un récepteur (17,53) sensible au rayonnement (15) situé dans la seconde rainure (7) et disposé pour capter les faisceaux, le récepteur - (17,53) émettant un signal de sortie ayant deux niveaux différents suivant que le récepteur reçoit ou non le faisceau. La paroi de fond (5) est en matériau transparent et le commutateur comprend en outre une source de lumière visible (26,54) disposée derrière la paroi de fond (5) de la gorge (2) et orientée pour éclairer l'intérieur de la gorge à travers la paroi de fond et des moyens (30,34,36) pour commander la source (26,54) en fonction de la valeur du signal de sortie du récepteur sensible (17,53).

Application aux commutateurs statiques.

FIG. 1

## COMMUTATEUR STATIQUE A COMMANDE MANUELLE

La présente invention concerne les commutateurs statiques du type à commande manuelle, c'est-à-dire tous dispositifs qui permettent de délivrer à au moins une borne de sortie un signal apte à prendre au moins deux niveaux, un des deux niveaux étant obtenu quand on applique par exemple manuellement un élément à un endroit déterminé. Elle concerne aussi l'application de ces commutateurs à la commande séquentielle d'éléments, par exemple électroniques, en fonction d'une position déterminée d'un élément déplaçable de préférence manuellement.

Il existe déjà des commutateurs comme ceux qui ont été définis ci-dessus qui peuvent être commandés manuellement. Généralement, ils comportent sous une paroi souple deux contacts disposés l'un en regard de l'autre, et soumis à l'action de moyens de ressort de répulsion, par exemple en un matériau non conducteur de l'électricité. Pour commander un tel commutateur, il suffit, au moyen par exemple directement ou indirectement d'un doigt, d'exercer sur la paroi souple une légère pression pour amener au contact les deux contacts qui établissent alors la fonction de commutation, par exemple pour la fermeture d'un circuit. Ce système donne de bons résultats mais demande malgré tout des précautions d'utilisation, car des forces de pression trop importantes peuvent entraîner plus ou moins vite la destruction des contacts, surtout dans des applications particulières, comme par exemple la commande de différents éléments musicaux dans des salles de spectacles où les dispositifs sont souvent soumis à de rudes épreuves de manipulation.

Il existe par contre d'autres commutateurs entièrement statiques qui comprennent généralement une source de faisceaux d'ondes électromagnétiques, une cellule réceptrice des faisceaux placée à une certaine distance de la source pour pouvoir laisser se déplacer entre eux un élément comme par exemple le doigt d'une main.

Ces dispositifs répondent bien entendu aux fonctions demandées. Cependant, dans le cas d'une application comme par exemple à un potentiomètre de réglage dans une table de mixage sonore, ils peuvent présenter éventuellement deux inconvénients. Tout d'abord, l'utilisateur n'a pas la sensation de toucher qui est nécessaire, par exemple dans le cas mentionné ci-dessus et ensuite, il ne sait pas exactement à quel endroit il a positionné son doigt.

Aussi, la présente invention a-t-elle pour but de réaliser un commutateur du type statique, avantageusement commandable manuellement, fiable, permettant de donner aux utilisateurs potentiels des sensations de toucher, leur permettant, de plus, de savoir si la commutation a été effectuée et, plus particulièrement, dans un système à multi-commutations, quelle commutation a été effectuée.

Plus précisément, la présente invention a pour objet un commutateur statique du type à commande manuelle, caractérisé par le fait qu'il comporte :

-un corps, ledit corps comportant au moins une gorge avec une paroi de fond transparente, ladite gorge étant bordée de chaque côté par une première et une seconde rainures, de façon que ladite gorge ait au moins deux parois transparentes à au moins un rayonnement électromagnétique, situées latéralement à la paroi de fond, sensiblement parallèles entre elles.

-au moins un émetteur de faisceaux dudit rayonnement électromagnétique disposé dans la première rainure et de façon à envoyer lesdits faisceaux vers ladite seconde rainure,

-un récepteur sensible audit rayonnement électromagnétique situé dans ladite seconde rainure et disposé pour être apte à capter ledit faisceau émis par ladite source, ledit récepteur étant apte à émettre un signal de sortie ayant au moins deux niveaux différents suivant que ledit récepteur reçoit ou pas ledit faisceau,

-une source de lumière visible disposée derrière la paroi de fond de ladite gorge et orientée pour éclairer l'intérieur de ladite gorge à travers ladite paroi de fond, et

-des moyens pour commander ladite source en fonction de la valeur dudit signal de sortie dudit récepteur sensible.

D'autres caractéristiques et avantages de la présente invention apparaîtront au cours de la description suivante donnée en regard des dessins annexés à titre illustratif mais nullement limitatif dans lesquels :

-les Figures 1 et 2 représentent suivant deux vues en coupe perpendiculaire un même mode de réalisation d'un commutateur selon l'invention.

-la Figure 3 représente sous forme - schématique et partielle un mode de réalisation d'un commutateur selon l'invention dans une application particulière, en substance, la commande d'un potentiomètre dont les valeurs des variations se font par palier.

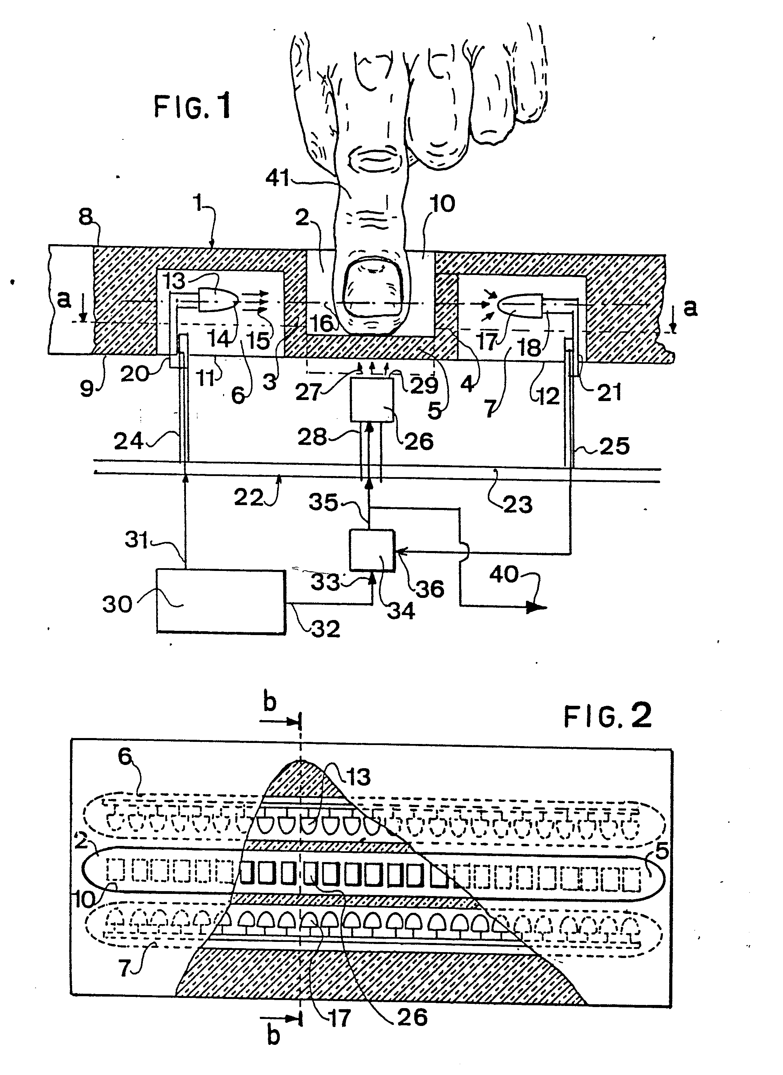

Les Figures 1 et 2, représentant un même mode de réalisation, il est donc implicite que les mêmes références désignent les mêmes moyens.

La Figure 1 est une vue en coupe selon b-b de la Figure 2 et la Figure 2 est une vue en écorché selon a-a de la Figure 1.

Le dispositif illustré concerne un commutateur du type statique tel que défini au préambule de la description, commutateur qui est apte à être commandé manuellement, notamment par application d'un doigt, comme il apparât de façon - schématique sur la Figure 1.

Plus précisément, le commutateur comprend un corps 1, de préférence en un matériau transparent tel que, par exemple, une matière plastique, dans lequel sont réalisées une gorge 2 et deux rainures 6 et 7. La gorge 2 est délimitée latéralement par deux parois 3 et 4 et par un fond 5, les deux parois 3 et 4, de préférence parallèles, séparant la gorge 2 respectivement des deux rainures 6 et 7. Le corps 1 a une forme sensiblement plane délimitée par deux faces sensiblement parallèles 8 et 9. De ce fait et dans ce mode de réalisation, la gorge 2 a son ouverture 10 sur la face 8 du corps 1, tandis que les deux rainures 6 et 7 ont leur ouverture respective 11 et 12 tournée vers la face 9.

La gorge 2 et les deux rainures 6 et 7 réalisées dans ce corps 1 en forme de plaque sont réalisées de façon que l'épaisseur des parois latérales 3 et 4 et de la paroi de fond 5 soit suffisamment importante pour pouvoir résister à des pressions qui peuvent être exercées par un doigt, même de forte intensité, mais néanmoins suffisamment mince pour permettre à un faisceau d'ondes électromagnétiques visibles, par exemple de l'ordre de 6 000 Angström ou non visibles, par exemple de 10 600 Angström, de traverser ce matériau sans subir une atténuation importante. Comme il sera explicité ci-après, dans une forme avantageuse de réalisation, ce rayonnement sera choisi dans le domaine de l'invisible, comme par exemple celui émis par une diode laser AsGa.

Le commutateur comporte au moins un émetteur d'ondes électromagnétiques 13 disposé dans la rainure 6 de façon que sa surface émettrice 14 soit apte à émettre le faisceau d'ondes électromagnétiques 15 sur l'axe optique 16 qui, comme représenté sur les Figures 1 et 2, est sensiblement perpendiculaire aux deux parois latérales 3 et 4 qui, elles-mêmes, sont avantageusement parallèles et de façon que cet axe optique passe sensiblement dans le milieu de l'autre rainure 7 et donc aussi dans le milieu de la gorge 2. De ce fait, quand l'émetteur 13 émet son faisceau 15, celui-ci peut se propager suivant l'axe 16 en traversant les deux parois latérales 3 et 4 et tomber dans la rainure 7 si aucun obstacle n'est présent dans la gorge 2.

Sur l'axe optique 16 est situé, dans la deuxième rainure 7, un récepteur sensible 17 aux rayonnements électromagnétiques émis par l'émetteur 13. Ce récepteur sensible 17 est lui-même apte à délivrer à sa sortie 18 un signal généralement de forme électrique dont la valeur de l'amplitude est une fonction de la quantité d'ondes électromagnétiques reçue par sa surface sensible et, en tout état de cause, de délivrer un signal à au moins deux niveaux suivant que ce récepteur 17 reçoit ou non ce faisceau d'ondes électromagnétiques émis par l'émetteur 13.

Bien entendu, ces deux éléments, l'émetteur 13 et le récepteur 17, sont disposés, par exemple, au moyen respectivement de leurs pattes de branchement 20 et 21, sur une embase de circuit imprimé 22 réalisée, dans ce mode de réalisation, en forme de U avec une partie basse 23 et deux parties latérales 24 et 25, la partie latérale 24 servant de support et de connexion aux bornes de sortie 20 de l'émetteur 13 et la partie latérale 25 servant elle-même de support aux bornes de sortie 21 du récepteur sensible 17. L'embase 23 permet, elle, d'assurer les connexions entre différents éléments et l'émetteur et le récepteur, et d'éventuels extérieurs, comme par exemple, même, des pattes de fixation sur d'autres éléments.

Sous la paroi de fond 5 de la gorge 2, par rapport à l'intérieur de cette gorge, est située une source 26 de lumière visible 27. Cette source 26 est disposée, par exemple elle aussi au moyen de ses bornes de connexion 28, sur l'embase 23 de circuit imprimé 22, de telle façon que sa surface d'émission 29 soit tournée vers la paroi de fond 5 et que les faisceaux 27 émis par cette source 26 puissent traverser cette paroi de fond 5 pour être vus par un observateur se trouvant au-dessus de l'ouverture 10 de cette gorge 2.

Le commutateur tel qu'illustré sur la Figure 1 comporte en plus une source d'énergie 30 comportant autant de bornes que nécessaire pour alimenter l'ensemble des trois éléments actifs, en l'occurrence l'émetteur 13, le récepteur 17 et la source 26. Très schématiquement, cette source d'énergie 30 comporte une première borne de sortie 31 qui est reliée aux bornes de connexion 20 de l'émetteur 13, une deuxième borne de sortie 32 reliée à une première entrée 33 d'une porte logique 34 dont la sortie 35 est reliée aux bornes de connexion 28 de la source 26 de lumière visible. Cette porte logique 34 comporte une entrée de commande 36 qui est connectée aux bornes de sortie 21 du récepteur sensible 17. Ces connexions se font de façon très classique, au moyen de circuits imprimés que l'on trouve couramment dans le domaine électronique.

La fonction de la porte logique 34 est définie de façon que, lorsque le récepteur sensible 17 reçoit un signal lumineux en provenance de l'émetteur 13, il délivre à sa sortie 18 un signal électrique dont le niveau est adapté pour que, lorsqu'il est appliqué à l'entrée 36 de cette porte logique 34, cette porte logique constitue un interrupteur permettant une non-alimentation de la source lumineuse 26 qui ne peut alors émettre son faisceau lumineux visible 27. Dans ce cas, la porte logique 34 est dans un état dit "non-passant". Par contre, lorque le récepteur 17 ne reçoit pas les faisceaux 15 émis par l'émetteur 13, le signal de sortie qu'il délivre à sa sortie 18 et appliqué à l'entrée 36 de la porte logique 34 permet à la source lumineuse 26 d'être alimentée et donc de pouvoir émettre ses faisceaux lumineux visibles 27, la porte logique 34 étant, dans ce cas, dans un état dit "passant".

Ce qui vient d'être décrit, en regard plus particulièrement de la Figure 1, représente le schéma de principe d'un commutateur à une position, c'est-à-dire que, à la sortie 35 de la porte logique 34, et plus particulièrement à la borne 40, on obtient un signal du type analogique "0-1" suivant que, comme illustré sur la Figure 1, un élément se trouve positionné ou non dans la gorge 2, comme part exemple le doigt 41 d'un utilisateur. Ce commutateur permet donc d'obtenir à la sortie 40 le signal tel que défini précédemment au préambule de la présente description.

Le fonctionnement du dispositif tel que décrit ci-dessus est le suivant :

Il est concevable que, si on veut obtenir à la sortie 40 un signal, un utilisateur postionne son doigt 41 sur le fond 5 de la gorge 2, qu'il appuie ou non de façon importante sur cette paroi. La force avec laquelle il appuie n'a pas d'importance, du fait de la rigidité de la paroi de fond 5 qui ne craint absolument aucune déformation, le dispositif présentant de ce fait toutes les conditions voulues pour une durée de vie importante. Quand l'utilisateur positionne son doigt 41 dans la gorge 2, il interrompt le faisceau électromagnétique 15 qui ne peut tomber sur la surface sensible du récepteur 17. Celui-ci délivre comme mentionné précédemment, un signal permettant de rendre la porte logique 34 passante. La source lumineuse 26 est alors alimentée et émet un faisceau lumineux 27, en même temps qu'apparaît à la sortie 40 un signal qui peut être utilisé pour différentes applications.

On voit donc les différents avantages d'un tel dispositif qui, en l'espèce, permet cumulativement d'être commandé manuellement par un utilisateur potentiel qui, de surcroît, n'aura pas de crainte d'appuyer sur le fond 5 de la gorge 2, puisque celle-ci n'a aucune action mécanique. Par contre, l'utilisateur aura la sensation d'avoir appuyé sur une touche comme il en a l'habitude pour d'autres éléments du même type. Enfin, avec ce système, il sera certain de savoir qu'il a bien commandé le commutateur puisque, uniquement lorsqu'il aura positionné son doigt 41 dans la gorge 2, la source lumineuse 26 sera allumée. On voit, ici, l'intérêt d'utiliser un émetteur 13 de lumière non-visible, pour ne pas interférer avec celle de la source 26.

La Figure 2 représente un même mode de réalisation que la Figure 1, comme mentionné précédemment. Cependant, dans cette vue, il apparaît nettement que le commutateur peut comporter une pluralité d'ensembles comportant, comme décrit ci-dessus, le corps 1, l'émetteur 13, le récepteur 17 et la source 26, ces trois derniers étant situés sensiblement dans un même plan. Les ensembles seront disposés parallèlement les uns aux autres, de façon qu'un utilisateur ayant positionné son doigt dans la gorge 2, ici de forme oblongue, puisse d'une part le déplacer aisément et d'autre part savoir instantanément sur quelle position il est, puisque les différentes sources lumineuses 26 seront allumées en fonction de la position du doigt.

La Figure 2 représente une pluralité d'ensembles associés en ligne qui peut être utilisée dans différentes applications, et notamment, comme mentionné au préambule, dans les commandes potentiométriques, sur les tables de mixage qui sont courantes dans les activités musicales, d'enregistrement, ou de restitution sonore pour spectacle.

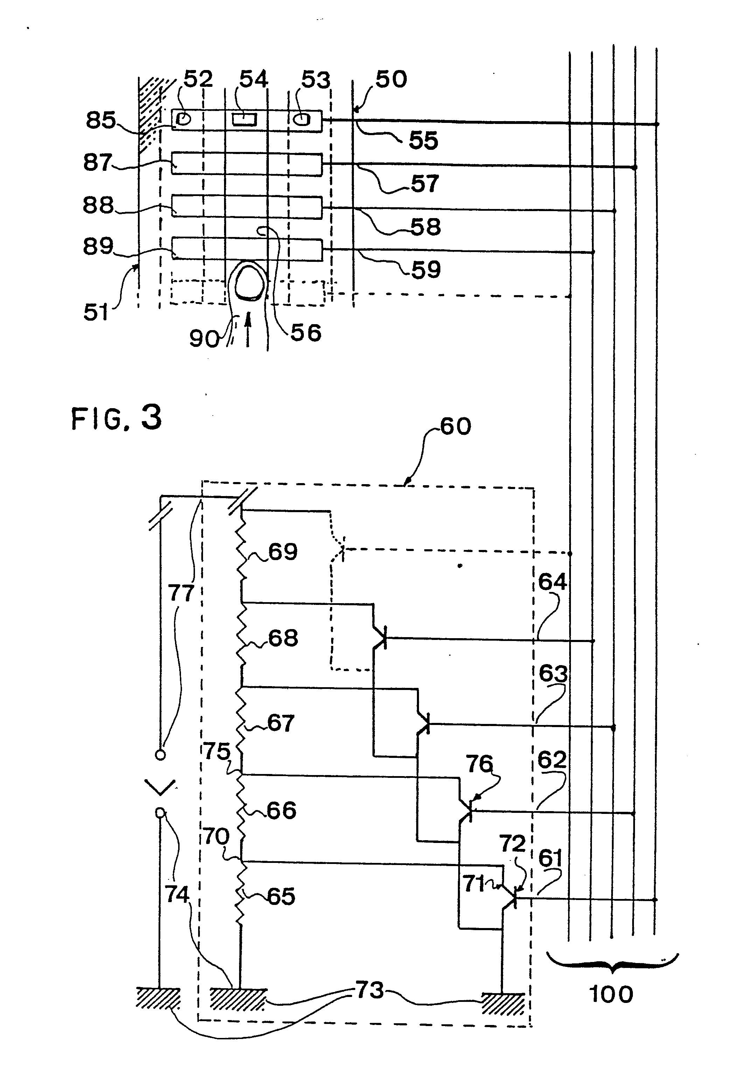

La Figure 3 représente un commutateur 50 permettant des commandes pas à pas d'un potentiomètre 60.

Le commutateur 50 comprend, dans un seul corps 51, avantageusement réalisée totalement dans un matériau transparent, une pluralité d'ensembles 85, 87, 88, 89, ... comme décrits précédemment, formé chacun d'éléments associés, notamment d'un émetteur 52, d'un récepteur 53, et d'une source lumineuse 54, ainsi que d'une sortie 55. Les différents ensembles 85, 87, 88, 89, ... sont situés les uns à côté des autres et de façon qu'un seule gorge 56 passe rectilignement entre les couples émetteur-récepteur et en regard des sources lumineuses. Ainsi, en déplaçant par exemple un doigt 90 dans la gorge 56, il apparaîtra sur les différentes sorties 55, 57, 58, 59, ... des signaux, par exemple logiques, qui permettront l'identification de la position du doigt dans la gorge 56. Les sorties 55, 57, 58, 59 ... du commutateur 50 sont reliées aux entrées identifiées correspondantes 61, 62, 63, 64, ... du potentiomètre 60. Les moyens de liaison entre ces sorties et ces entrées sont généralement constituées par un ligne de type "bus" 100.

Le potentiomètre 60 illustré est constitué par une série de résistances 65, 66, 67, 68, 69, ... montées en série. Chaque point commun de liaison entre deux résistances consécutives est relié par exemple à un potentiel de référence, comme la masse, à travers le circuit émetteur-récepteur d'un transistor. Le type et le sens de branchement des transistors illustrés sur la Figure 3 n'ont pas été précisés car cette technique est bien connue et elle est du domaine de l'homme de l'art qui saura choisir le type de transistor adapté et son sens du branchement.

Ceci étant précisé, on peut voir que, par exemple, le point commun 70 entre les deux résistances 65 et 66 est relié par le circuit émetteur-récepteur 71 du transistor 72 à la masse 73. L'extrémité 74 de l'ensemble de la série de résistances est, elle aussi, directement reliée à la masse 73. Bien entendu, il en est de même pour les autres points des résistances consécutives, par exemple le point 75 entre les deux résistances 66 et 67 qui est relié à la masse 73 à travers le transistor 76, et ainsi de suite pour les autres points communs. L'autre extrémité 77 de l'ensemble des résistances constitue avec l'extrémité 74 les deux bornes d'utilisation du potentiomètre 60. Ces deux bornes peuvent alors être connectées à un circuit qui à été référence "V" sur la Figure 3.

L'association du commutateur 50 avec le potentiomètre 60 fonctionne de la façon suivante:

On suppose tout d'abord qu'un utilisateur veuille, par exemple, faire varier un niveau sonore pour une application musicale dans le domaine du spectacle. Pour obtenir une telle variation de niveau, on sait que l'on doit faire varier la valeur d'un signal électrique au moyen, par exemple, d'un potentiomètre. Donc, dans le cas illustré sur la Figure 3, l'utilisateur va passer l'extrémité de son doigt 90 dans la gorge 56, en le déplaçant le long de celle-ci, si nécessaire. Par ce déplacement, les différentes sorties 55, 57, 58, 59 ... vont délivrer un signal identifié en fonction de la position du doigt dans la gorge 56. Il est précisé que, comme décrit ci-avant, l'utilisateur sait à quel endroit de la gorge il a précisément positionné son doigt par le fait que la source lumineuse sera allumée sur cette position et qu'il pourra voir sa lumière à travers le fond de la gorge 56. S'il veut commander une certaine valeur de la résistance du potentiomètre, il positionne son doigt à l'endroit de la gorge qui aura été préalablement repéré pour une valeur donnée de la resistance.

A titre d'exemple, s'il positionne son doigt au niveau de l'ensemble 89, un signal est obtenu à la sortie 59. Ce signal transmis par la ligne bus 100 est appliqué à l'entrée 64. Ceci rend le transistor associé passant, ce qui entraîne une mise en court-circuit de l'ensemble des résistances 68, 67, 66, 65, et la valeur de résistance du potentiomètre est égale à la valeur uniquement de la résistance 69.

Par contre, en positionnant son doigt au niveau de l'ensemble 85, le signal délivré à la sortie 55, appliqué au transistor 72 va entraîner la mise en court-circuit de la résistance 65 et la valeur de la résistance du potentiomètre sera égale à la somme des résistances 66, 67, 68, 69, ...

Maintenant, si l'utilisateur veut obtenir une variation sensiblement continue (du moins pas par pas), il peut déplacer son doigt le long de la gorge 56 et la valeur de la résistance totale du potentiomètre 60 aura une variation correspondant à chaque passage au niveau des ensembles 85, 87, 88, 89, ... à l'addition ou à la soustraction, suivant le sens du déplacement du doigt, d'une des résistances 65, 66, 67, 68, 69, ...

Il est bien précisé que l'exemple illustré n'est qu'un mode de réalisation dans une application particulière et que le commutateur pourra comprendre un nombre plus important d'ensembles 85, 87, 88, 89, et donc, par exemple, commander une variation du potentiomètre par des valeurs plus fines et/ou en plus grande quantité.

**Revendications**

1. Commutateur statique du type à commande manuelle, comprenant :

-un corps (1, 51), ledit corps comportant au moins une gorge (2, 56) avec une paroi de fond (5), ladite gorge (2) étant bordée de chaque côté par une première (6) et une seconde (7) rainures, de façon que ladite gorge (2) ait au moins deux parois (3, 4) transparentes à au moins un rayonnement électromagnétique, situées latéralement à la paroi de fond, sensiblement parallèles entre elles,

-au moins un émetteur (13, 52) de faisceaux dudit rayonnement électromagnétique disposé dans la première rainure (6) de façon à envoyer lesdits faisceaux vers ladite seconde rainure (7),

-un récepteur (17, 53) sensible audit rayonnement électromagnétique (15) situé dans ladite seconde rainure (7) et disposé pour être apte à capter ledit faisceau émis par ledit émetteur, ledit récepteur - (17, 53) étant apte à émettre un signal de sortie ayant au moins deux niveaux différents suivant que ledit récepteur reçoit ou non ledit faisceau, CARACTERISE PAR LE FAIT QUE ladite paroi de fond (5) est en matériau transparent et que ledit commutateur comprend en outre,

-une source de lumière visible (26, 54) disposée derrière la paroi de fond (5) de ladite gorge (2) et orientée pour éclairer l'intérieur de ladite gorge à travers ladite paroi de fond, et

-des moyens (30, 34, 36) pour commander ladite source (26, 54) en fonction de la valeur dudit signal de sortie dudit récepteur sensible (17, 53).

2. Commutateur selon la revendication 1, CARACTERISE PAR LE FAIT QUE ledit corps (1, 51) est réalisé en un matériau transparent audit rayonnement électromagnétique et à ladite lumière visible.

3. Commutateur selon la revendication 2, CARACTERISE PAR LE FAIT QUE ledit corps (1, 51) est constitué par une plaque délimitée par deux faces (8, 9) sensiblement parallèles, ladite gorge (2, 56) débouchant par une ouverture (10) sur une première face (8) et les deux dites rainures (6, 7) débouchant par une ouverture (11, 12) sur l'autre deuxième face (9).

4. Commutateur selon la revendication 3, CARACTERISE PAR LE FAIT QUE ledit émetteur (13, 52), ledit récepteur (17, 53) et ladite source (26, 54) sont solidaires d'une embase (22) de circuit imprimé.

5. Commutateur selon la revendication 4, CARACTERISE PAR LE FAIT QUE ladite embasè (22) est sensiblement en forme de "U" et comporte une partie basse (23) sensiblement parallèle à ladite deuxième face (9) et deux parties latérales (24, 25) situées respectivement en regard des deux dites rainures (6, 7), l'émetteur (13) et le récepteur (17) étant montés respective ment sur les deux dites parties latérales (24, 25) et ladite source lumineuse (26) sur ladite partie basse (23), entre les deux dites parties latérales et en regard de ladite gorge.

6. Commutateur selon l'une des revendications 1 à 5, CARACTERISE PAR LE FAIT QUE ledit émetteur (13, 52) d'ondes électromagnétiques est une source de lumière invisible.

7. Commutateur selon la revendication 6, CARACTERISE PAR LE FAIT QUE ladite source de lumière invisible (13, 52) est une source de lumière infrarouge.

8. Commutateur selon l'une des revendications précédentes 1 à 7, CARACTERISE PAR LE FAIT QU'il comporte une pluralité d'émetteurs (52) de faisceaux de rayonnement électromagnétique juxtaposés dans une même première rainure, une pluralité de récepteurs (53) juxtaposés dans une même deuxième rainure et une pluralité de sources lumineuses (54) juxtaposés sous une même gorge (56), les deux dites rainures et ladite gorge étant situées sur des axes sensiblement parallèles, à chaque émetteur (52) étant associé un récepteur (53) et des moyens pour commander une source (54) par le signal délivré par ledit récepteur.

9. Commutateur selon la revendication 8, CARACTERISE PAR LE FAIT QU'un émetteur (13, 52), un récepteur (17, 53) associé audit émetteur et une source de lumière (26, 54) commandée par ledit récepteur sont situés sensiblement sur un même plan.

FIG. 1

FIG. 2

FIG. 3

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| X | DE-A-2 723 398 (THOMA AUFZÜGE) <br><br> * Page 7 - page 12, ligne 6; figures 1-4 * | 1,2,6, 7 . | H 03 K 17/94 <br> H 03 K 17/18 |
| Y | AU-B- 16 267 (THORNTON ET AL.)(1976) <br> * Page 4, ligne 7 - page 6, ligne 19; page 16, lignes 6-12; figures 1-3 * | 1,6-8 | |
| Y | DE-A-3 146 152 (HAAG et al.) <br> * Page 4, lignes 25-34; page 10, lignes 5-30; figures 4,5 * | 1,6-8 | |
| A | | 9 | |
| A | EP-A-0 057 446 (TOKYO KOGAKU KIKAI) <br> * Page 6, ligne 4 - page 7, ligne 26; figures 1-3 * | 1,3,5-9 | DOMAINES TECHNIQUES RECHERCHES (Int. Cl.4) <br><br> H 03 K |

Le présent rapport de recherche a été établi pour toutes les revendications

| Lieu de la recherche | Date d'achèvement de la recherche | Examinateur |
|---|---|---|
| LA HAYE | 09-07-1986 | CANTARELLI R.J.H. |